(19) **Europäisches Patentamt / European Patent Office / Office européen des brevets**

(11) **EP 2 109 142 A1**

(12) **EUROPEAN PATENT APPLICATION**
published in accordance with Art. 153(4) EPC

(43) Date of publication:
**14.10.2009 Bulletin 2009/42**

(21) Application number: **08703828.7**

(22) Date of filing: **24.01.2008**

(51) Int Cl.:
**H01L 27/105** (2006.01)   **C23C 14/34** (2006.01)
**H01L 45/00** (2006.01)

(86) International application number:
**PCT/JP2008/051001**

(87) International publication number:
**WO 2008/090963 (31.07.2008 Gazette 2008/31)**

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **25.01.2007 JP 2007015059**

(71) Applicant: **ULVAC, INC.**
**Chigasaki-shi**
**Kanagawa 253-8543 (JP)**

(72) Inventors:
• **KIKUCHI, Shin**
**Susono-shi**
**Shizuoka 410-1231 (JP)**

• **NISHIOKA, Yutaka**
**Susono-shi**
**Shizuoka 410-1231 (JP)**
• **KIMURA, Isao**
**Susono-shi**
**Shizuoka 410-1231 (JP)**
• **JIMBO, Takehito**
**Susono-shi**
**Shizuoka 410-1231 (JP)**
• **SUU, Koukou**
**Susono-shi**
**Shizuoka 410-1231 (JP)**

(74) Representative: **Eisenführ, Speiser & Partner**
**Patentanwälte Rechtsanwälte**
**Postfach 31 02 60**
**80102 München (DE)**

(54) **METHOD FOR FORMING CHALCOGENIDE FILM AND METHOD FOR MANUFACTURING RECORDING ELEMENT**

(57)   A method for forming a chalcogenide film within a contact hole formed in an insulating layer on a substrate, includes: preparing a target having a composition the same as that of the chalcogenide film; setting a ratio L/T of a distance L with respect to a diameter T of the target to a value not less than 0.5 and not more than 1.5, where the diameter of the target is T (m) and the distance between the target and the substrate is L (m); and forming a chalcogenide film within the contact hole by a sputtering process in which a bias electric power is applied to the substrate and a sputtering electric power is applied to the target.

*FIG. 1*

**Description**

TECHNICAL FIELD

The present invention relates to a method for forming a chalcogenide film by means of sputtering, and in more detail, relates to a method for forming, by means of sputtering, a dense chalcogenide film with a stoichiometric composition that is suitably used for a recording layer of a highly integrated memory such as phase change memory capable of nonvolatile operation, and that has no defects such as gaps and cracks therein.
The present invention also relates to a method for manufacturing a recording element including the above method for forming a chalcogenide film, and in particular, to a method for manufacturing a resistance variable type recording element.
The present patent application claims priority based on Japanese Patent Application No. 2007-15059, filed January 25, 2007, the contents of which are incorporated herein by reference.

BACKGROUND ART

In recent years, in mobile devices such as mobile telephones and mobile information terminals, there has been an increasing need for handling a large amount of information such as image data. Also in memory elements to be installed in these mobile devices there has been an increasing demand for a high speed, low power consumption, and small nonvolatile memory with a large capacity. In particular, a resistance variable type nonvolatile memory (resistance variable type recording element) which uses a chalcogen compound whose resistance changes depending on its crystal condition, has been drawing attention as a memory that is highly integrated and capable of nonvolatile operation (for example, refer to Patent Document 1).
This resistance variable type nonvolatile memory has a simple structure in which two electrodes sandwich a chalcogenide film that serves as a recording layer, and is capable of stably maintaining the recording state thereof even at room temperature. Therefore it is an excellent memory sufficiently capable of holding memory for more than ten years.
[Patent Document 1] Japanese Unexamined Patent Application, First Publication No. 2004-348906

DISCLOSURE OF INVENTION

[Problems to be Solved by the Invention]

Incidentally, in a conventional resistance variable type nonvolatile memory, if the size of the elements is simply miniaturized in order to achieve high integration, the gap between adjacent elements becomes extremely narrow. Therefore, there has been a problem in that for example if, in order to cause a phase change in a recording layer of a single element, a predetermined electric voltage is applied to electrodes thereabove and therebelow, the heat emitted from the lower electrode may have a negative influence on the adjacent elements.
Consequently, there may be considered a structure where an insulating layer with a low thermal conductivity is formed on a substrate, and a hole with a small diameter is formed in this insulating layer and a chalcogen compound is embedded within this hole, to thereby separate the elements. However, in this structure, it is difficult to densely embed a chalcogen compound in the hole, and it is difficult to obtain a dense chalcogenide film.
Moreover, since the chalcogen compound contains volatile chalcogen elements, a part of the volatile chalcogen elements is volatilized during the film forming process, and the composition of the obtained chalcogenide film is deviated from its stoichiometric composition. Therefore it is difficult to form a chalcogenide film in a state in which its stoichiometric composition is maintained.
The present invention has been achieved in order to solve the above problems, with an object of providing a method for forming a chalcogenide film by means of sputtering, capable of forming a dense chalcogenide film with a stoichiometric composition, having no defects such as gaps and cracks therein.
A further object of the present invention is to provide a method for manufacturing a recording element by applying the above chalcogenide film forming method.

[Means for Solving the Problems]

The present inventors earnestly investigated the method of forming a chalcogenide film by means of sputtering, and as a result, discovered that when forming a chalcogenide film within a contact hole in an insulating layer by means of sputtering, in a case where a target having a composition the same as that of the chalcogenide film is used and the diameter of this target is T (m) and the distance between this target and the substrate is L (m), if the ratio L/T of the distance with respect to the diameter of the target is not less than 0.5 and not more than 1.5, it is possible to form a dense chalcogenide film with a stoichiometric composition, having no defects such as gaps and cracks therein. Consequently, the present inventors have completed the present invention.

The present invention provides a method for forming a chalcogenide film within a contact hole formed in an insulating layer on a substrate, the method including: preparing a target having a composition the same as that of the chalcogenide film; setting a ratio L/T of a distance L with respect to a diameter T of the target to a value not less than 0.5 and not more than 1.5, where the diameter of the target is T (m) and the distance between the target and the substrate is L (m); and forming a chalcogenide film within the contact hole by a sputtering process in which a bias electric power is applied to the substrate and a sputtering electric power is applied to the target.

Furthermore, the present invention provides a method for manufacturing a recording element that includes a chalcogenide film, the method including: forming, on a substrate, an insulating layer having a contact hole with an enlarged diameter upper section; forming a first electrode within the contact hole; preparing a target having a composition the same as that of the chalcogenide film; setting a ratio L/T of a distance L with respect to a diameter T of the target to a value not less than 0.5 and not more than 1.5, where the diameter of the target is T (m) and the distance between the target and the substrate is L (m); forming, on the first electrode, a chalcogenide film that serves as a recording layer, by a sputtering process in which a bias electric power is applied to the substrate and a sputtering electric power is applied to the target; and forming a second electrode on the chalcogenide film.

In the above method for forming a chalcogenide film and the method for manufacturing a recording element, it is preferable that in a case where a surface area of the substrate is $S_s$ (cm$^2$), a bias electric power thereof is $P_s$ (W), a surface area of the target is $S_t$ (cm$^2$), and a sputtering electric power thereof is $P_t$ (W), a ratio Ds / Dt of a power density Ds of the substrate with respect to a power density Dt of the target satisfy the following expression (1):

$$\text{Ds / Dt} = (P_s \times S_t) / (P_t \times S_s) \leq 0.1 \qquad (1).$$

Preferably the power density Ds of the substrate and the power density Dt of the target are optimized to thereby densely fill in the contact hole with the chalcogenide film, while maintaining a stoichiometric composition thereof.
Preferably the chalcogenide film includes a chalcogen compound containing at least one element selected from the group consisting of S, Se, and Te.
Preferably the chalcogen compound contains: Te not less than 30% by weight and not more than 60% by weight; Ge not less than 10% by weight and not more than 70% by weight; Sb not less than 10% by weight and not more than 40%; and Se not less than 10% by weight and not more than 70%, and the total content ratio of these Te, Ge, Sb, and Se is not more than 100% by weight.

Preferably the first and second electrodes contain at least one element selected from the group consisting of Ti, Zr, Hf, V, Nb, Ta, Cr, Mo, W, Ru, Pt, and Ir.

[Effects of the Invention]

According to the method of the present invention for forming a chalcogenide film by means of sputtering, in a case where the diameter of the target having a composition the same as that of the chalcogenide film is T (m) and the distance between this target and the substrate is L (m), the ratio L/T of the distance L with respect to the diameter T of the target is not less than 0.5 and not more than 1.5. Consequently, it is possible, in a state where the sputtering rate is maintained at an optimum condition, to form, within the contact hole in the insulating layer, a dense chalcogenide film with a stoichiometric composition, having no defects such as gaps and cracks therein.
Moreover, a bias electric power is applied to the substrate and a sputtering electric power is applied to the target. As a result it is possible to form a dense chalcogenide film in a state where the composition of the film containing volatile chalcogen elements maintains its stoichiometric composition.

According to the method of the present invention for manufacturing a recording element that includes the chalcogenide film as a recording layer, in a case where the diameter of the target having a composition the same as that of the chalcogenide film is T (m) and the distance between this target and the substrate is L (m), the ratio L/T of the distance L with respect to the diameter T of the target is not less than 0.5 and not more than 1.5. Consequently, it is possible, in a state where the sputtering rate is maintained at an optimum condition, to form, within the contact hole, a dense chalcogenide film with a stoichiometric composition, having no defects such as gaps and cracks therein.
Moreover, a bias electric power is applied to the substrate and a sputtering electric power is applied to the target. As a result it is possible to form a dense chalcogenide film in a state where the composition of the film containing volatile chalcogen elements maintains its stoichiometric composition.
Therefore, it is possible to provide a recording element in which the recording layer is formed with a dense chalcogenide film with a stoichiometric composition, having no defects such as gaps and cracks thereinside.

BRIEF DESCRIPTION OF THE DRAWINGS

FIG. 1 is a schematic sectional view showing a sputtering apparatus used in a method for forming a chalcogenide film by means of sputtering, according to an embodiment of the present invention.

FIG. 2 is a sectional view showing a silicon wafer used in manufacturing a phase change type memory.

FIG. 3 is a sectional view showing a phase change type memory of the present embodiment formed on a silicon wafer.

FIG. 4 is a diagram showing a relationship between coverage ratio ($t_B/t_i$), sputtering rate, and L/T.

FIG. 5 is a diagram showing a relationship between content ratio of chalcogen elements in a chalcogenide film, and $(P_s \times S_t)/(P_t \times S_s)$ (= Ds / Dt).

FIG. 6 is a scanning type electron microscope image showing a sectional shape of a chalcogenide film in a case where the chalcogenide film is formed by means of sputtering while a bias electric power $P_s$ (W) is being applied to a specimen.

FIG. 7 is a scanning type electron microscope image showing a sectional shape of a chalcogenide film in a case where the chalcogenide film is formed by means of sputtering without a bias electric power $P_s$ (W) being applied to the specimen.

FIG. 8 is a scanning type electron microscope image showing a sectional shape of a chalcogenide film formed by means of a conventional sputtering method.

[Description of the Reference Symbols]

1: cooling stage with electrostatic chuck, 2: specimen, 3: target, 4: magnet, 5, 6: power supply, 11: silicon wafer, 12: insulating layer, 13: contact hole, 13a: enlarged diameter section, 14: tungsten, 15: titanium nitride (TiN), 16: lower electrode (first electrode), 17: chalcogenide film, 18: upper electrode (second electrode)

BEST MODE FOR CARRYING OUT THE INVENTION

There is described a best mode for carrying out a method for forming a chalcogenide film by means of sputtering of the present invention.

This mode is to give a specific description for a better understanding of the intent of the invention, and should not be construed as limiting the present invention unless otherwise stated.

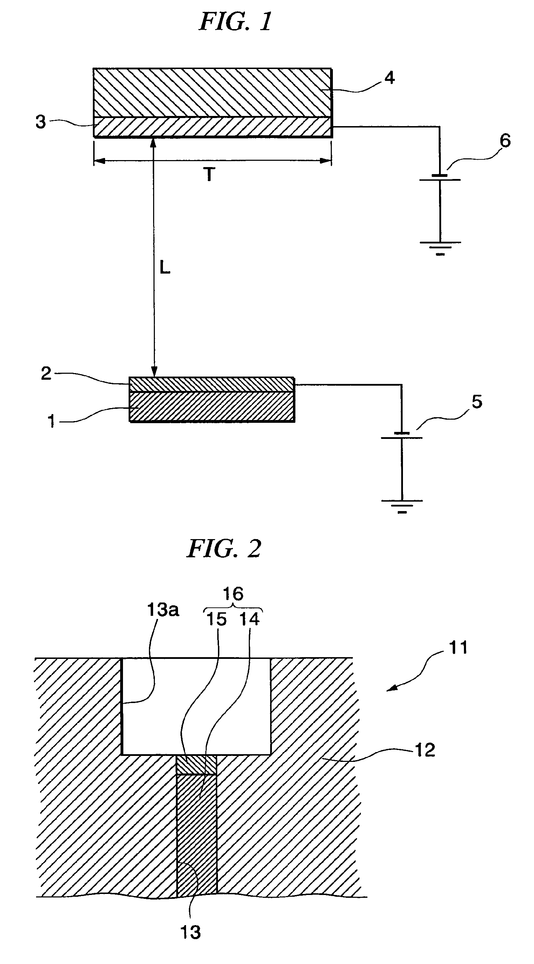

FIG. 1 is a schematic sectional view showing a sputtering apparatus used in a method for forming a chalcogenide film by means of sputtering, according to an embodiment of the present invention. In this drawing: reference symbol 1 denotes a cooling stage with an electrostatic chuck provided within a vacuum chamber (not shown in the drawing); reference symbol 2 denotes a specimen formed with a disk shaped substrate that is adsorbed and fixed on the cooling stage with the electrostatic chuck, by an electrostatic force; reference symbol 3 denotes a target arranged opposite to the upper surface of the specimen 2; reference symbol 4 denotes a magnet that is provided on the upper section side of the target 3 so as to fix the target 3 with magnetic force; reference symbol 5 denotes a power supply that applies a bias electric power $P_s$ (W) to the specimen 2; and reference symbol 6 denotes a power supply that applies a sputtering electric power $P_t$(W) to the target 3.

If the distance between this target 3 and the specimen 2 is L (m) and the diameter of this target 3 is T (m), the ratio L/T of this distance L and the diameter T of the target 3 is adjusted to be not less than 0.5 and not more than 1.5, preferably, not less than 0.7 and not more than 1.3.

For this target 3, a target material consisting of a chalcogen compound, which is a material having a composition the same as that of the chalcogenide film to be formed is suitable, and specific examples of this chalcogen compound include a chalcogen compound containing at least one element selected from a group consisting of S, Se, and Te. More specifically, examples of this include a chalcogen compound containing: Te not less than 30% by weight and not more than 60% by weight; Ge not less than 10% by weight and not more than 70% by weight; Sb not less than 10% by weight and not more than 40%; and Se not less than 10% by weight and not more than 70%, and the total content ratio of these Te, Ge, Sb, and Se is not more than 100% by weight.

Specific examples of this chalcogen compound include $Ge_2Sb_2Te_5$, $GeSb_2Te_5$, and GeSe.

The specimen 2 may have a contact hole for forming the chalcogenide film, and for example, a silicon wafer (substrate) 11 shown in FIG. 2 is suitable therefor.

This silicon wafer 11 is a wafer used in manufacturing a phase change type memory (resistance variable type recording element) with a chalcogenide film serving as a recording layer, in which, on an insulating layer 12 made of silicon oxide formed on a semiconductor circuit or the like (not shown in the drawing) of a silicon substrate, there is formed a contact hole 13 that reaches this semiconductor circuit, and an upper section of this contact hole 13 has an enlarged diameter and serves as an enlarged diameter section 13a. Within the contact hole 13 except for this enlarged diameter section 13a, there is formed a lower electrode (first electrode) 16 of the phase change type memory having a two-layer structure of tungsten (W) 14 and titanium nitride (TiN) 15.

This lower electrode 16, as with an upper electrode (second electrode) 18 formed on the chalcogenide film described later, may be electrically conductive, and in addition to the above composition, any one of a metal, an alloy metal, a metallic oxide, and a metallic nitride with an electrically conductive property containing at least one type of material selected from the group consisting of Ti, Zr, Hf, V, Nb, Ta, Cr, Mo, W, Ru, Pt, and Ir, may preferably be used.

Next, with use of the above sputtering apparatus, the chalcogenide film is formed within the enlarged diameter section 13a of the silicon wafer 11 shown in FIG. 2.

In this film formation, in order to form a dense chalcogenide film in a state where the composition of the film containing volatile chalcogen elements maintains its stoichiometric composition, a bias electric power $P_s$ (W) is applied to the specimen 2 with use of the power supply 5 and a sputtering electric power $P_t$ (W) is applied to the target 3 with use of the power supply 6.

In order to optimize these bias electric power $P_s$ (W) and sputtering electric power $P_t$ (W), when the surface area of the specimen 2 is $S_t$ (cm$^2$), the bias electric power thereof is $P_s$ (W), the surface area of the target 3 is $S_t$ (cm$^2$), and the sputtering electric power thereof is $P_t$ (W), the ratio Ds / Dt of the power density Ds of the specimen 2 with respect to the power density Dt of the target 3 needs to satisfy the following expression (1):

$$Ds / Dt = (P_s \times S_t) / (P_t \times S_s) \leq 0.1 \qquad (1).$$

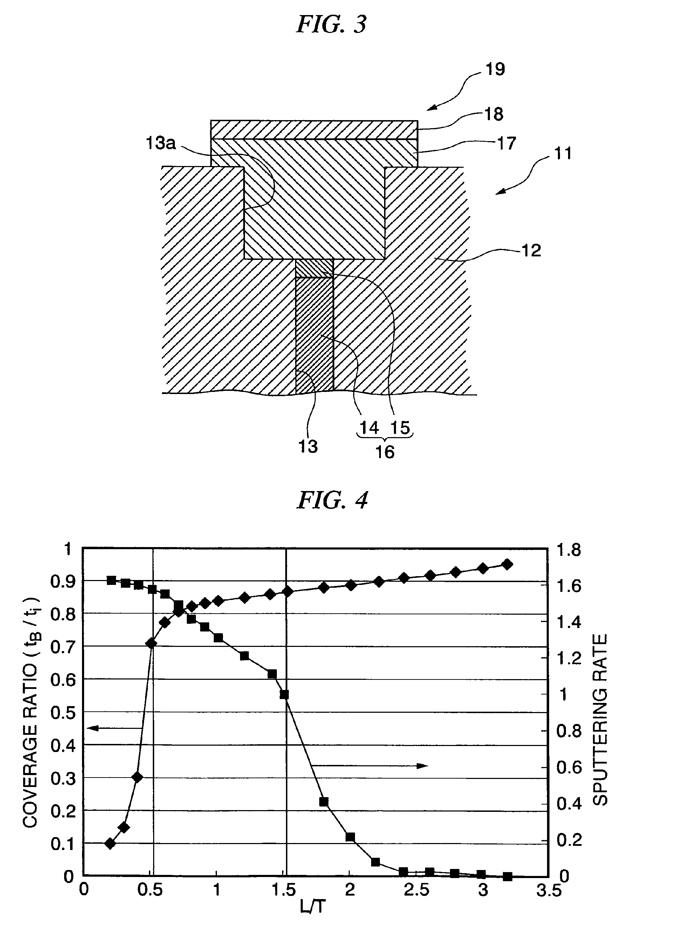

By optimizing these bias electric power $P_s$ (W) and sputtering electric power $P_t$ (W), volatilization of volatile chalcogen elements is suppressed to a minimum. Therefore the composition of the chalcogenide film to be formed becomes the same as that of the target 3, while the stoichiometric composition of the chalcogenide film is maintained. Moreover, it becomes unlikely to have a gap or the like within the film, and therefore the density of the film is improved. As a result, as shown in FIG. 3, within the enlarged diameter section 13a of the silicon wafer 11 there is formed a dense chalcogenide film 17 that has an extremely low level of defects such as gaps and that maintains its stoichiometric composition. This chalcogenide film 17, in the case of the phase change type memory, becomes a recording layer and has excellent flatness. Therefore chemical mechanical polishing (CMP) or the like is not required.

Next, on this chalcogenide film 17 there is formed an upper electrode (second electrode) 18. This upper electrode 18, as with the lower electrode 16, may be electrically conductive, and for example, may be an electrode having a two-layer structure of tungsten (W) and titanium nitride (TiN), or preferably has a single layer structure or a lamination structure formed with any one of a metal, an alloy metal, a metallic oxide, and a metallic nitride with an electrically conductive property containing at least one type of material selected from the group consisting of Ti, Zr, Hf, V, Nb, Ta, Cr, Mo, W, Ru, Pt, and Ir.

Thereby, it is possible to manufacture a phase change type memory 19 with the chalcogenide film 17 serving as a recording layer.

Next, there are described results of an experiment carried out by the present inventors, regarding the method of forming a chalcogenide film by means of sputtering according to the present embodiment.

FIG. 4 is a diagram showing a relationship between coverage ratio ($t_B / t_i$), sputtering rate, and the ratio L/T of the distance L (m) between the target 3 and the specimen 2 with respect to the diameter T (m) of the target 3. Here the coverage ratio ($t_B / t_i$) refers to a ratio of the film thickness ($t_B$) of the chalcogenide film formed on the bottom surface of the enlarged diameter section 13a with respect to the film thickness ($t_i$) of the chalcogenide film formed on the insulating layer 12 outside the enlarged diameter section 13a, when forming the chalcogenide film on the insulating layer 12 including the contact hole 13.

Referring to FIG. 4, L/T is not less than 0.5 in the case where the coverage ratio ($t_B / t_i$) is not less than 0.7 in order to ensure the in-plane homogeneity of the chalcogenide film. Moreover, L/T is not more than 1.5 in the case where sputtering rate is 1.0 while taking the productivity of the chalcogenide film into consideration. Therefore, the L/T range that satisfies both of the coverage ratio ($t_B / t_i$) and the sputtering rate is not less than 0.5 and not more than 1.5, preferably not less than 0.7 and not more than 1.3.

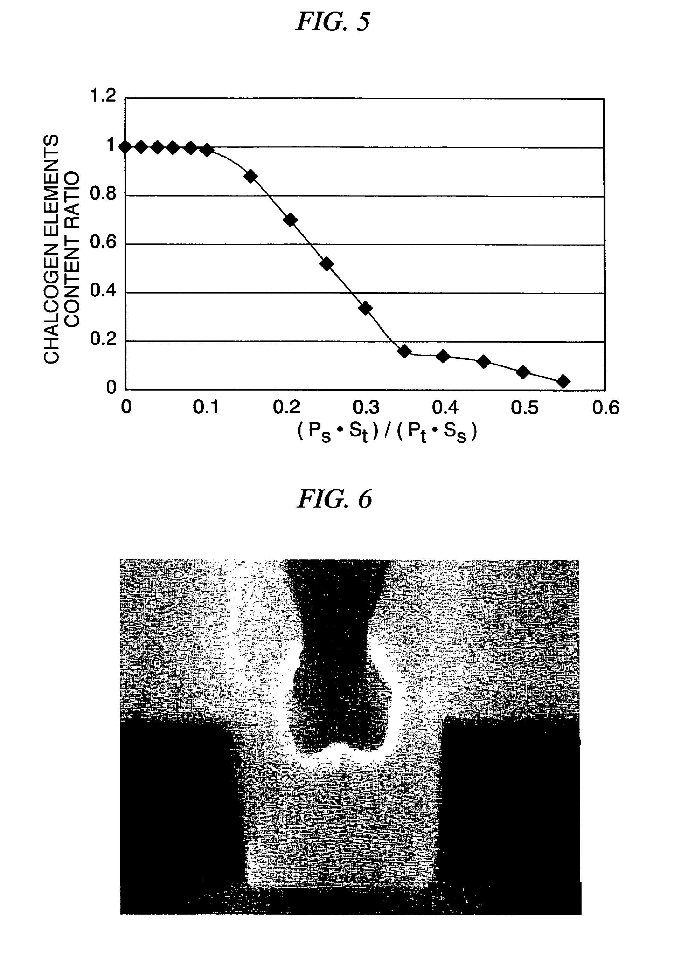

FIG. 5 is a diagram showing a relationship between content ratio of chalcogen elements in the chalcogenide film and ($P_s \times S_t$) / ($P_t \times S_s$) (= Ds / Dt).

Here, the composition of the chalcogenide film is $Ge_2Sb_2Te_5$.

Referring to FIG. 5, it can be seen that the ratio of the contained chalcogen elements such as Ge and Te rapidly decreases when ($P_s \times S_i$) / ($P_t \times S_s$) exceeds 0.1, and the ratio of the contained chalcogen elements significantly decreases to 0.2 or less when ($P_s \times S_t$) / ($P_t \times S_s$) further exceeds 0.35.

FIG. 6 is a scanning type electron microscope (SEM) image showing the sectional shape of a chalcogenide film within the enlarged diameter section 13a in a case where the chalcogenide film is formed by means of sputtering while applying a bias electric power $P_s$ (W) to the specimen 2 under a condition of L/T = 1.0.

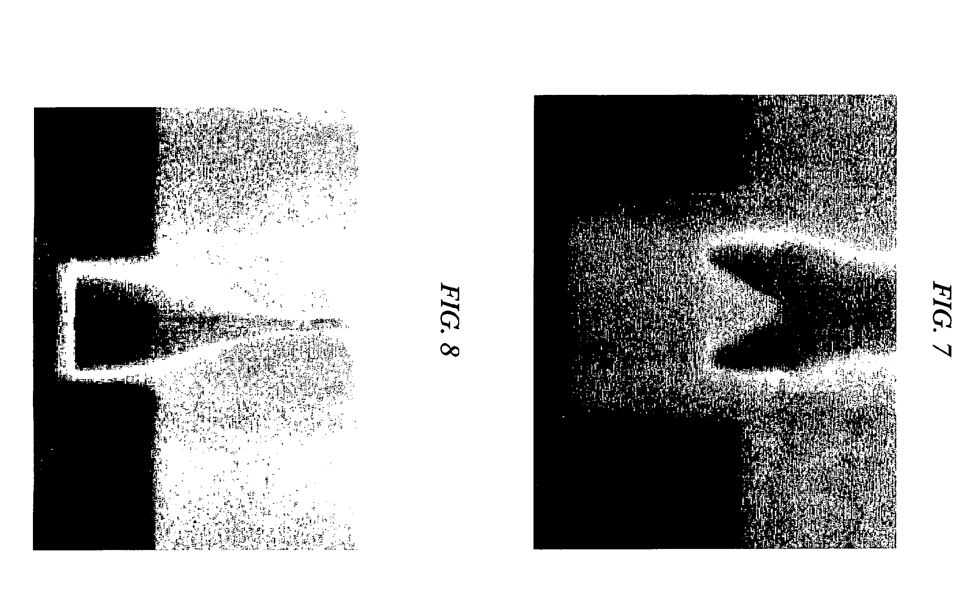

FIG. 7 is a scanning type electron microscope (SEM) image showing the sectional shape of a chalcogenide film within the enlarged diameter section 13a in a case where the chalcogenide film is formed by means of sputtering while applying no bias electric power $P_s$ (W) to the specimen 2 under a condition of L/T =1.0.

FIG. 8 is a scanning type electron microscope (SEM) image showing the sectional shape of a chalcogenide film within the enlarged diameter section 13a in a case where the chalcogenide film is formed on the specimen 2 by means of sputtering under a condition of L/T = 0.2, which is a conventional sputtering method.

According to these diagrams, it is understood that in the case where a bias electric power $P_s$ (W) is applied to the specimen 2, a predetermined thickness is ensured for the chalcogenide film formed within the enlarged diameter section 13a, the surface thereof is flattened, and the quality of the film is excellent.

Moreover, it is understood that in the case where a bias electric power $P_s$ (W) is not applied to the specimen 2, while a conically shaped protrusion is formed on the surface of the chalcogenide film formed within the enlarged diameter section 13 a, a predetermined thickness is ensured, the surface thereof is flattened, and the quality of the film is excellent.

On the other hand, in the case of the conventional example, the thickness of the chalcogenide film formed within the enlarged diameter section 13a is extremely thin, the electrical characteristic of the film is significantly inconsistent, and the quality of the film is inferior.

As described above, according to the method for forming a chalcogenide film by means of sputtering according to the present embodiment, in the case where the diameter of the target 3 having a composition the same as that of the chalcogenide film is T (m) and the distance between this target 3 and the specimen 2 is L (m), the ratio L/T of the distance L with respect to the diameter T of the target 3 is not less than 0.5 and not more than 1.5. Consequently, it is possible, in a state where the sputtering rate is maintained at an optimum condition, to form, within the enlarged diameter section 13a of the contact hole 13, a dense chalcogenide film 17 with a stoichiometric composition, having no defects such as gaps and cracks therein.

Moreover, since a bias electric power is applied to the specimen 2, it is possible, in a state where the composition of the film containing volatile chalcogen elements maintains its stoichiometric composition, to form a dense chalcogenide film having a flat surface.

Therefore, it is possible to provide a resistance variable type recording element in which a recording layer is formed with a dense chalcogenide film with a stoichiometric composition, having no defects such as gaps and cracks therein.

INDUSTRIAL APPLICABILITY

The present invention may be utilized in forming a dense chalcogenide film with a stoichiometric composition, having no defects such as gaps and cracks therein, and may also be utilized in manufacturing a resistance variable type recording element having such a chalcogenide film that serves as a recording layer.

**Claims**

1. A method for forming a chalcogenide film within a contact hole formed in an insulating layer on a substrate, the method comprising:

   preparing a target having a composition the same as that of the chalcogenide film;
   setting a ratio L/T of a distance L with respect to a diameter T of the target to a value not less than 0.5 and not more than 1.5, where the diameter of the target is T (m) and the distance between the target and the substrate is L (m); and
   forming a chalcogenide film within the contact hole by a sputtering process in which a bias electric power is applied to the substrate and a sputtering electric power is applied to the target.

2. A sputtering method for a chalcogenide film according to claim 1, wherein in a case where a surface area of the substrate is $S_s$ (cm$^2$), a bias electric power applied to the substrate is $P_s$ (W), a surface area of the target is $S_t$ (cm$^2$), and a sputtering electric power applied to the target is $P_t$ (W), a ratio Ds / Dt of a power density Ds of the substrate with respect to a power density Dt of the target satisfy the following expression (1):

$$Ds / Dt = (P_s \times S_t) / (P_t \times S_s) \le 0.1 \qquad (1).$$

3. A method for forming a chalcogenide film according to claim 2, wherein the power density Ds of the substrate and the power density Dt of the target are optimized to thereby densely fill in the contact hole with the chalcogenide film, while maintaining a stoichiometric composition thereof.

4. A method for forming a chalcogenide film according to claim 1, wherein the chalcogenide film comprises a chalcogen compound containing at least one element selected from the group consisting of S, Se, and Te.

5. A method for forming a chalcogenide film according to claim 4, wherein the chalcogen compound contains: Te not less than 30% by weight and not more than 60% by weight; Ge not less than 10% by weight and not more than 70% by weight; Sb not less than 10% by weight and not more than 40%; and Se not less than 10% by weight and not more than 70%, and the total content ratio of these Te, Ge, Sb, and Se is not more than 100% by weight.

6. A method for manufacturing a recording element that includes a chalcogenide film, the method comprising:

forming, on a substrate, an insulating layer having a contact hole with an enlarged diameter upper section;
forming a first electrode within the contact hole;
preparing a target having a composition the same as that of the chalcogenide film;
setting a ratio L/T of a distance L with respect to a diameter T of the target to a value not less than 0.5 and not more than 1.5, where the diameter of the target is T (m) and the distance between the target and the substrate is L (m);
forming, on the first electrode, a chalcogenide film that serves as a recording layer, by a sputtering process in which a bias electric power is applied to the substrate and a sputtering electric power is applied to the target; and
forming a second electrode on the chalcogenide film.

7. A method for manufacturing a recording element according to claim 6, wherein in a case where a surface area of the substrate is $S_s$ (cm$^2$), a bias electric power applied to the substrate is $P_s$ (W), a surface area of the target is $S_t$ (cm$^2$), and a sputtering electric power applied to the target is $P_t$ (W), a ratio Ds / Dt of a power density Ds of the substrate with respect to a power density Dt of the target satisfy the following expression (1):

$$\mathrm{Ds} / \mathrm{Dt} = (P_s \times S_t) / (P_t \times S_s) \leq 0.1 \qquad (1).$$

8. A method for manufacturing a recording element according to claim 7, wherein the power density Ds of the substrate and the power density Dt of the target are optimized to thereby densely fill in the contact hole with the chalcogenide film, while maintaining a stoichiometric composition thereof.

9. A method for manufacturing a recording element according to claim 6, wherein the chalcogenide film comprises a chalcogen compound containing at least one element selected from the group consisting of S, Se, and Te.

10. A method for manufacturing a recording element according to claim 9, wherein the chalcogen compound contains: Te not less than 30% by weight and not more than 60% by weight; Ge not less than 10% by weight and not more than 70% by weight; Sb not less than 10% by weight and not more than 40%; and Se not less than 10% by weight and not more than 70%, and the total content ratio of these Te, Ge, Sb, and Se is not more than 100% by weight.

11. A method for manufacturing a recording element according to claim 6, wherein the first and second electrodes contain at least one element selected from the group consisting of Ti, Zr, Hf, V, Nb, Ta, Cr, Mo, W, Ru, Pt, and Ir.

*FIG. 1*

*FIG. 2*

*FIG. 3*

*FIG. 4*

*FIG. 5*

*FIG. 6*

*FIG. 7*

*FIG. 8*

| INTERNATIONAL SEARCH REPORT | International application No. |
|---|---|
| | PCT/JP2008/051001 |

A. CLASSIFICATION OF SUBJECT MATTER
*H01L27/105(2006.01)i, C23C14/34(2006.01)i, H01L45/00(2006.01)i*

According to International Patent Classification (IPC) or to both national classification and IPC

B. FIELDS SEARCHED

Minimum documentation searched (classification system followed by classification symbols)
H01L27/105, C23C14/34, H01L45/00

Documentation searched other than minimum documentation to the extent that such documents are included in the fields searched
Jitsuyo Shinan Koho 1922-1996 Jitsuyo Shinan Toroku Koho 1996-2008
Kokai Jitsuyo Shinan Koho 1971-2008 Toroku Jitsuyo Shinan Koho 1994-2008

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | JP 2006-344948 A (Hynix Semiconductor Inc.),<br>21 December, 2006 (21.12.06),<br>Par. Nos. [0007], [0035] to [0039]<br>& US 2006/0278899 A1 | 6,9,11<br>1-5,7-8,10 |
| Y<br>A | JP 2006-137962 A (Mitsubishi Materials Corp.),<br>01 June, 2006 (01.06.06),<br>Par. Nos. [0010] to [0011]; table 1<br>(Family: none) | 6,9,11<br>1-5,7-8,10 |
| A | JP 2005-117030 A (Mitsubishi Materials Corp.),<br>28 April, 2005 (28.04.05),<br>Par. Nos. [0015] to [0019]<br>& JP 2005-117002 A & JP 2005-117031 A<br>& US 2007/0053786 A1 & EP 1667230 A1<br>& WO 2005/029585 A1 | 1-11 |

☒ Further documents are listed in the continuation of Box C.      ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 19 February, 2008 (19.02.08) | 26 February, 2008 (26.02.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

| INTERNATIONAL SEARCH REPORT | International application No. |
|---|---|
| | PCT/JP2008/051001 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2006-344976 A  (Hynix Semiconductor Inc.), 21 December, 2006 (21.12.06), Par. No. [0036]; Fig. 2E & US 2006/0284159 A1 | 1-11 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007015059 A
- JP 2004348906 A